(19) Europäisches Patentamt
European Patent Office
Office européen des brevets

(11) **EP 3 660 929 B1**

(12) **FASCICULE DE BREVET EUROPEEN**

(45) Date de publication et mention
de la délivrance du brevet:
**08.03.2023 Bulletin 2023/10**

(21) Numéro de dépôt: **19211112.8**

(22) Date de dépôt: **25.11.2019**

(51) Classification Internationale des Brevets (IPC):
**H01L 31/107** $^{(2006.01)}$ **H01L 31/0296** $^{(2006.01)}$

(52) Classification Coopérative des Brevets (CPC):
**H01L 31/1075; H01L 31/02966**

(54) **PHOTODIODE SAM À MULTIPLICATION D'UN SEUL TYPE DE PORTEURS DANS UNE RÉGION À MULTICOUCHE PÉRIODIQUE**

**SAM-FOTODIODE MIT MULTIPLIKATION EINES EINZIGEN TRÄGERTYPS IN EINEM PERIODISCHEN MEHRSCHICHTIGEN BEREICH**

**SAM PHOTODIODE WITH MULTIPLICATION OF A SINGLE TYPE OF CARRIERS IN A PERIODIC MULTI-LAYER REGION**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.11.2018 FR 1871956**

(43) Date de publication de la demande:
**03.06.2020 Bulletin 2020/23**

(73) Titulaire: **Commissariat à l'énergie atomique et aux énergies alternatives**
**75015 Paris (FR)**

(72) Inventeur: **ROTHMAN, Johan**
**38054 GRENOBLE CEDEX 09 (FR)**

(74) Mandataire: **Brevalex**
**Tour Trinity**
**1 Bis Esplanade de La Défense**
**CS 60347**
**92035 Paris La Défense Cedex (FR)**

(56) Documents cités:
**US-A1- 2013 221 193 US-B1- 6 747 296**

• **ANDREW S. HUNTINGTON ET AL: "Improved breakdown model for estimating dark count rate in avalanche photodiodes with InP and InAlAs multiplication layers", PROCEEDINGS OF THE SPIE - THE INTERNATIONAL SOCIETY FOR OPTICAL ENGINEERING SPIE - VERTICAL-CAVITY SURFACE-EMITTING LASERS XIII, vol. 6214, 5 mai 2006 (2006-05-05), page 62140R, XP055613659, SPIE OPTO: INTEGRATED OPTOELECTRONIC DEVICES24-29 January 2009San Jose, California, United States ISSN: 0277-786X, DOI: 10.1117/12.668659**

**Description**

**DOMAINE TECHNIQUE**

L'invention concerne les photodiodes à avalanche, et plus particulièrement les photodiodes à zones d'absorption et de multiplication séparées (dites SAM-APD pour « Separate Absorption and Multiplication région - Avalanche PhotoDiode ») qui réalisent une multiplication de porteurs par ionisation par impact d'un seul type de porteurs.

**ÉTAT DE LA TECHNIQUE ANTÉRIEURE**

Certaines applications de détection de la lumière au moyen d'une photodiode à avalanche, telles que la télédétection par laser LIDAR (« Light Détection And Ranging »), l'optique quantique ou les télécommunications dans l'espace libre, requièrent la détection d'un faible nombre de photons par temps d'observation. Or la conservation de l'information contenue par un flux de photons est fondamentalement limitée par le rendement quantique de la photodiode qui décrit sa capacité à transformer chaque photon incident en signal électrique, et par le facteur d'excès de bruit de la photodiode qui traduit le bruit ajouté par la multiplication des charges électriques réalisée par la photodiode.
Un pas important vers des photodiodes à valeur d'excès de bruit réduite a été réalisé avec l'arrivée de matériaux, tels que les tellurures de mercure-cadmium CdHgTe, qui permettent d'obtenir une multiplication de porteurs par ionisation par impact prépondérante pour un type de porteurs. En effet, de tels matériaux permettent d'éviter, comme notamment démontré dans l'article de revue de J. Rothman intitulé « Physics and Limitations of HgCdTe APDs: A Review », Journal of Electronic Materials, 2018, une interaction parasite entre les deux types de porteurs circulant dans la zone de multiplication. Il en résulte une réduction importante du bruit généré dans cette zone et un temps de réponse amélioré.
Cet article rapporte ainsi, pour une photodiode SAM-ADP à base de CdHgTe présentant une couche de multiplication réalisée avec une composition de Cd constant, un facteur d'excès de bruit F de l'ordre de 1,2 à 1,3. Cette faible valeur est due non seulement à une multiplication des porteurs dans la couche de multiplication qui est exclusivement initiée par les électrons mais également par la présence d'un effet d'espace mort qui tend à spatialement regrouper les événements de multiplication. À titre de comparaison, les photodiodes à avalanche à base de semi-conducteur III-V ou Si sont caractérisées par une multiplication des deux types de porteurs et les valeurs de facteur d'excès de bruit F observées sont supérieures à 2 pour les photodiodes à base de Si, et supérieures à 3 voire 5 pour les photodiodes à base de matériaux III-V.
Si la faible valeur d'excès de bruit d'une photodiode SAM à multiplication d'un seul type de porteur en fait un des détecteurs les plus performants pour les applications qui impliquent la détection d'un faible nombre de photons, il n'en reste pas moins que ce niveau d'excès de bruit peut rester problématique pour certaines applications, telles que la détection de photons uniques où il peut empêcher de distinguer avec certitude la détection d'un ou de deux photons.
Les documents US 6747296 et US 2013/221193 décrivent des photodiodes à avalanche procédant par ionisation par impact d'un seul type de porteurs, généralement des électrons.

**EXPOSÉ DE L'INVENTION**

L'invention a pour objectif de fournir une photodiode SAM à multiplication de porteurs par ionisation par impact d'un seul type de porteurs qui présente une sensibilité accrue, caractérisée par un facteur d'excès de bruit F réduit.
A cet effet, l'invention propose une photodiode à avalanche telle que définie par la revendication 1.
Certains aspects préférés mais non limitatifs de cette photodiode sont définis dans les revendications dépendantes.

**BRÈVE DESCRIPTION DES DESSINS**

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

- la figure 1 est schéma selon une vue en coupe d'une photodiode conforme à l'invention ;
- la figure 2 illustre la variation de la largeur de bande interdite d'énergie au sein d'une structure multicouche de la région de multiplication d'une photodiode selon l'invention ;
- la figure 3 illustre un exemple de variation du coefficient d'ionisation par impact en fonction de la distance parcourue par un électron après avoir été sujet d'un événement de multiplication. ;
- la figure 4 illustre, en fonction de la même distance D, la densité de probabilité de multiplication Pm ;
- la figure 5 illustre des valeurs de gain et de facteur d'excès de bruit pour différentes photodiodes conformes à

EP 3 660 929 B1

l'invention ;

- la figure 6 illustre la variation de la largeur de bande interdite d'énergie au sein d'une structure multicouche soumise à une polarisation inverse de la région de multiplication d'une photodiode selon un mode de réalisation avantageux de l'invention ;
- la figure 7 représente des probabilités de multiplication dans une deuxième couche d'une structure multicouche de la région de multiplication d'une photodiode selon l'invention ;
- les figures 8 et 9 représentent respectivement l'évolution du gain et l'évolution du facteur d'excès de bruit en fonction de la tension de polarisation inverse.

## EXPOSÉ DÉTAILLÉ DE MODES DE RÉALISATION PARTICULIERS

L'invention porte sur une photodiode SAM-APD à zones d'absorption et de multiplication séparées qui réalise une multiplication de porteurs par ionisation par impact d'un seul type de porteurs (multiplication dite SCM pour « Single Carrier Multiplication »). Par « multiplication de porteurs par ionisation par impact d'un seul type de porteurs », on entend que la multiplication par impact de l'un des types de porteurs (les trous par exemple) est négligeable vis-à-vis de la multiplication par impact de l'autre type de porteurs (les électrons dans cet exemple), c'est à dire que le rapport entre les deux taux de multiplication est supérieur à 50, préférentiellement 100, voire 1000.

Dans la suite de la description, la photodiode est réalisée à base de tellurure de mercure-cadmium, c'est-à-dire en un matériau comprenant le tellure et au moins un élément choisi parmi le cadmium et le mercure et respectant la formulation suivante $Cd_xHg_{1-x}Te$ avec la valeur x correspondant à la proportion de cadmium par rapport au mercure qui est comprise entre 0 et 1, 0 et 1 inclus. Néanmoins, l'invention ne se limite pas aux seules photodiodes réalisées à partir de tellurure de mercure-cadmium et englobe également tout type de structure dont la conception permet d'obtenir une multiplication prépondérante pour un type de porteurs, par exemple en ayant recours à des arséniures-antimoniures d'indium du type $InAs_{1-x}Sb_x$.

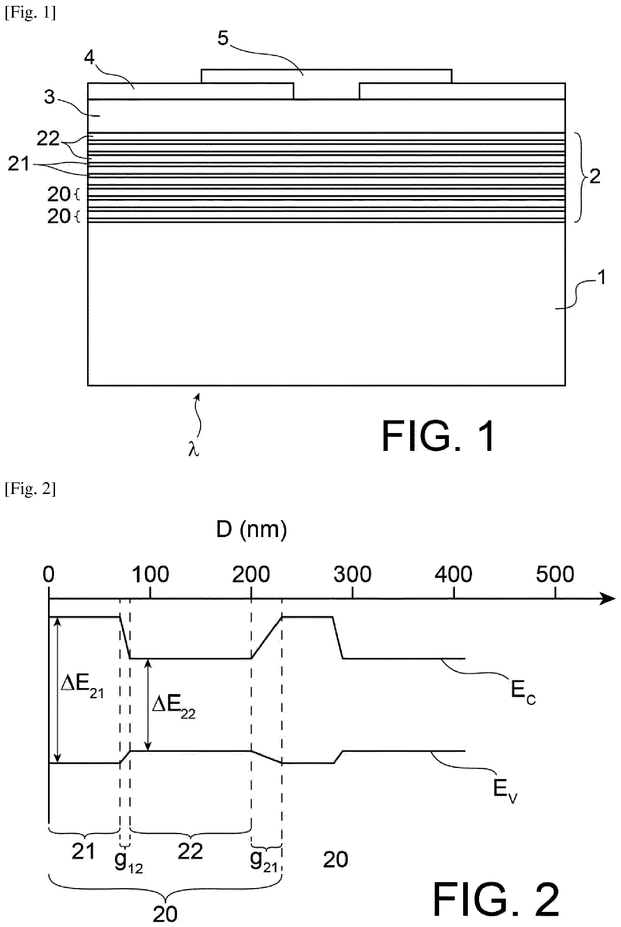

En référence à la figure 1, l'invention concerne une photodiode à avalanche destinée à la détection et la mesure d'un rayonnement électromagnétique $\lambda$ dont la longueur d'onde est comprise dans une gamme de longueurs d'onde donnée, par exemple une longueur d'onde de 1,55 $\mu$m comprise dans la gamme de longueurs d'ondes du proche infrarouge.

La photodiode est par exemple réalisée au moyen d'une croissance par épitaxie par jets moléculaires du matériau CdHgTe dont la composition en cadmium peut être modulée afin de faire varier la largeur de bande interdite d'énergie.

La photodiode comprend une région d'absorption 1, une région de collecte 3 et une région de multiplication 2 entre la région d'absorption et la région de collecte. La région de multiplication 2 réalise une multiplication de porteurs par ionisation par impact prépondérante pour les électrons (i.e. la multiplication des trous est négligeable vis-à-vis de la multiplication des électrons).

La région d'absorption 1 présente une première face sur laquelle la lumière est incidente. Cette région est caractérisée par un type de conductivité de type P et un niveau de dopage typiquement supérieur à $10^{16}$ cm$^{-3}$. L'épaisseur et la composition en cadmium de cette région sont adaptées à la longueur d'onde visée pour chaque application. Pour détecter des photons de longueur d'onde 1.55 $\mu$m, l'épaisseur est typiquement de l'ordre de 1,5 à 3 $\mu$m et le taux de cadmium x est typiquement supérieur à 0,3, par exemple supérieur à 0,45.

Les électrons générés dans la région d'absorption 1 sont transportés par dérive ou diffusion vers la région de multiplication 2. La région de multiplication 2 est caractérisée par un niveau de dopage faible par rapport à la région d'absorption, typiquement inférieur à $10^{16}$ cm$^{-3}$, afin d'établir un champ électrique uniforme au travers de cette région.

La région de collecte 3, avec laquelle la région de multiplication est en contact direct dans l'exemple de la figure 1, est caractérisée par un type de conductivité N et un niveau de dopage typiquement supérieur à $10^{16}$ cm$^{-3}$. La composition x en cadmium de la région de collecte 3 est par exemple compris entre 0,4 et 0,45.

La région de collecte 3 est recouverte d'une couche de passivation 4 utilisée pour protéger la photodiode d'une dégradation électrique induite par un mécanisme mécanique ou chimique. Un plot de métal 5 est localisé dans et autour d'un trou dans la couche de passivation 4 afin de disposer d'un contact électrique, idéalement ohmique, avec la région de collecte 3. Un contact électrique (non représenté) est également réalisé avec la région d'absorption 1 afin d'appliquer une polarisation entre les régions d'absorption et de collecte à travers la région de multiplication. Une limitation de la surface active des régions de multiplication et de collecte peut être réalisée au moyen d'une gravure venant définir un pilier en forme de mésa et/ou au moyen d'une formation localisée de la couche de collecte réalisée, par exemple, par implantation ionique.

Selon l'invention, la région de multiplication 2 comprend une pluralité de structures multicouches 20. Prenant également en référence la figure 2 qui représente la variation de la bande interdite d'énergie (« gap ») qui sépare les bandes de valence Ev et de conduction Ec dans une structure multicouche non polarisée, chaque structure multicouche 20 de la région de multiplication comprend, de la région d'absorption 1 vers la région de collecte 3, une première couche 21 présentant une première largeur de bande interdite d'énergie $\Delta E_{21}$ puis une deuxième couche 22 présentant une deuxième largeur de bande interdite d'énergie $\Delta E_{22}$. La première largeur de bande interdite d'énergie $\Delta E_{21}$ est supérieure à la deuxième largeur de bande interdite d'énergie $\Delta E_{22}$. De telle manière, la deuxième couche 22 présente un taux moyen de multiplication de porteurs par micromètre supérieur au taux moyen de multiplication de porteurs de la première couche 21. Pour ce faire, la première et la deuxième couches 21, 22 sont réalisées dans des tellurures de mercure-cadmium du type $Cd_xHg_{1-x}Te$ avec des proportions x en cadmium différentes l'une de l'autre, et plus particulièrement une teneur en cadmium $x_{cd1}$ de la première couche supérieure à la teneur en cadmium $x_{cd2}$ de la deuxième couche avec par exemple $x_{cd1}=0,45$ et $x_{cd2}=0,34$.

Lors du fonctionnement de la photodiode, i.e. lorsqu'elle est soumise à une polarisation inverse, telle qu'une polarisation comprise entre 10V et 15V, par exemple 13V, la première couche 21 forme une couche d'accélération des porteurs qui vient augmenter l'énergie des électrons sans initier d'événements de multiplication des électrons tandis que la deuxième couche forme une couche de multiplication au sein de laquelle sont localisés les événements de multiplication des électrons. La région de multiplication selon l'invention à pluralité de structures multicouches permet ainsi une localisation importante des événements de multiplication au sein des deuxièmes couches 22. De telle manière, l'aléa de multiplication est réduit et par conséquent la valeur du facteur d'excès de bruit est diminuée.

Dans un mode de réalisation possible, la variation de gap entre les première et deuxième couche n'est pas instantanée et chaque structure multicouche 20 comprend, de la région d'absorption 1 vers la région de collecte 2, une couche $g_{12}$ à gradient négatif de largeur de bande interdite d'énergie entre la première couche 21 et la deuxième couche 22 et une couche $g_{21}$ à gradient positif de largeur de bande interdite après la deuxième couche 22. Le gradient négatif de largeur de bande interdite passe de la première largeur de bande interdite d'énergie à la deuxième largeur de bande interdite.

Dans un mode de réalisation possible, le gradient positif de largeur de bande interdite passe de la deuxième largeur de bande interdite d'énergie à la première largeur de bande interdite, de telle manière que les structures multicouches présentent les mêmes largeurs de bande interdite d'énergie $\Delta E_{21}$ et $\Delta E_{22}$ au sein des première et deuxième couches.

Dans une variante de réalisation, les première et deuxième largeurs de bande interdite ainsi que les épaisseurs des première et deuxième couches diminuent d'une structure multicouche à une autre de la région d'absorption vers la région de collecte. La région de multiplication présente ainsi un gap et des épaisseurs plus importants du côté de la région d'absorption que du côté de la région de collecte. Cette variante permet de réduire la génération du courant d'obscurité en début de multiplication côté région d'absorption. Cette variante peut être utilisée pour obtenir un gain important tout en venant réduire, par comparaison avec une région de multiplication sous la forme d'une couche présentant une teneur en cadmium homogène, l'épaisseur de la région de multiplication ainsi que la valeur de polarisation inverse.

Dans un mode de réalisation possible permettant de garantir un transport par dérive et un temps de réponse rapides de la photodiode, la couche $g_{21}$ à gradient positif de largeur de bande interdite est plus épaisse que la couche $g_{12}$ à gradient négatif de largeur de bande interdite. Le gradient négatif est ainsi plus abrupt que le gradient positif, et le gradient positif augmente graduellement sur une distance correspondant à l'épaisseur $e_{21}$ de la couche $g_{21}$ ce qui permet d'obtenir un champ électrique nominal de fonctionnement $E_f$ supérieur à $\Delta E_g/e_{21}$ (où $\Delta E_g$ correspond à la différence d'énergie entre les bandes de valence et de conduction) et donc d'assurer un transport de porteurs sans barrière pour les électrons.

Un modèle décrivant le gain et l'excès de bruit dans les photodiodes à base de CdHgTe a été proposé dans l'article de J. Rothman et al. intitulé « History-Dependent Impact Ionization Theory Applied to HgCdTe e-APDs », Journal of Electronic Materials, n°40, page 1757, 2011. Ce modèle est utilisé dans ce qui suit pour décrire une réalisation avantageuse d'une photodiode selon l'invention, étant entendu que cette description ne dépend pas de l'exactitude de ce modèle mais de ces principaux paramètres à savoir un espace mort (i.e. la distance minimale qu'un électron nouvellement généré doit parcourir afin d'acquérir suffisamment d'énergie pour créer un nouvel évènement d'ionisation par impact) et une valeur de saturation du coefficient d'ionisation par impact après l'espace mort.

Afin d'obtenir un faible excès de bruit, inférieur à 2, cet article indique qu'il est indispensable d'utiliser un modèle d'ionisation par impact qui dépend de l'historique du porteur. Ainsi, le coefficient d'ionisation par impact $\alpha$ dans une position x doit tenir compte d'une distance d'espace mort $x_{ds}$ après le dernier évènement de multiplication qui a été initié

$$\alpha(x|x') = \frac{\alpha_h\left[\operatorname{erf}\left(\frac{x-x_{ds}}{\gamma x_{ds}}\right)+1\right]}{2},$$

par ou a généré un porteur à une position x' et cet article fournit l'équation suivante :

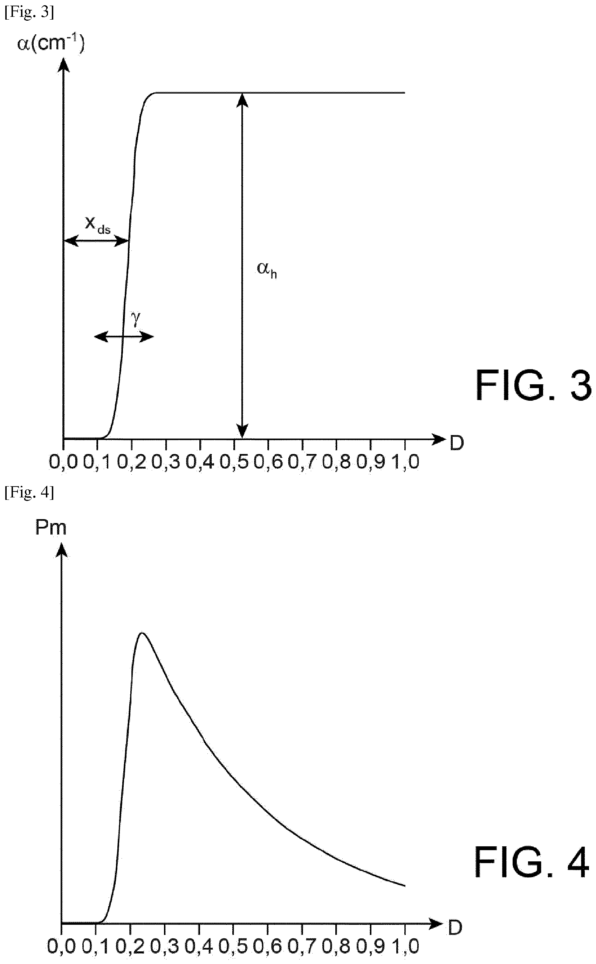

où erf désigne la fonction d'erreur, $\alpha_h$ correspond à la valeur de saturation du coefficient d'ionisation par impact après l'espace mort et $\gamma$ est une variable qui traduit une incertitude sur l'espace mort en impactant l'ionisation par impact autour de la distance de l'espace mort. On a représenté sur la figure 3 un exemple de variation du coefficient d'ionisation par impact $\alpha$ selon ce modèle en fonction de la distance D (ici exprimée proportionnellement à l'épaisseur de la jonction) parcourue par un électron après avoir été sujet d'un événement de multiplication. Et on a représenté sur la figure 4, en fonction de la même distance D, la densité de probabilité de multiplication Pm.

La variation de la distance d'espace mort $x_{ds}$ et de la valeur de saturation $\alpha_h$ du coefficient d'ionisation par impact après l'espace mort apparaissent déterminants pour modéliser correctement la variation du gain et du facteur d'excès de bruit en fonction de la polarisation inverse appliquée à la photodiode. Toujours dans le même article, il a été démontré qu'une bonne description du gain peut être obtenue en utilisant un modèle de Shockley de paramètres a et b pour exprimer l'évolution du coefficient d'ionisation par impact en fonction du champ électrique E :

$$\alpha(E) = aE\exp(-\frac{b}{E})$$

. La variation de la distance d'espace mort $x_{ds}$ est quant à elle décrite par $x_{ds}=ds/E$ avec par exemple ds=0,8 et $\gamma$=0,3.

Ainsi, dans chaque structure multicouche de la photodiode selon l'invention, la première couche 21 présente un taux de multiplication de porteurs par micromètre ayant une première valeur de saturation $\alpha_{h1}$ après une première distance d'espace mort $x_{ds1}$ et la deuxième couche 22 présente un taux de multiplication de porteurs par micromètre ayant une deuxième valeur de saturation $\alpha_{h2}$ après une deuxième distance d'espace mort $x_{ds2}$. Ces valeurs $\alpha_{h1}$, $\alpha_{h2}$, $x_{ds1}$ et $x_{ds2}$ varient en fonction des largeurs de bande d'énergie interdite $\Delta E_{21}$ et $\Delta E_{22}$ et du champ électrique de fonctionnement $E_f$.

Dans une réalisation avantageuse de l'invention, on vient réduire, voire supprimer l'aléa sur l'espace mort afin de réduire la valeur du facteur d'excès de bruit. Pour ce faire, on vient minimiser la probabilité de multiplication dans la première couche 21 des structures multicouche 20 en jouant sur son épaisseur pour obtenir un espace mort quasi-déterministe (i.e. $\gamma \approx 0$) et localiser les événements de multiplication au sein de la deuxième couche 22. A cet effet, dans chaque structure multicouche, la première couche 21 a une épaisseur $e_1$ inférieure à la première distance d'espace mort $x_{ds1}$ et au moins égale à la deuxième distance d'espace mort $x_{ds2}$ : $x_{ds2} \le e_1 < x_{ds1}$.

Et dans chaque structure multicouche 20, on peut prévoir que la deuxième couche 22 a une épaisseur $e_2$ supérieure à une distance de multiplication $1/\alpha_{h2}$ correspondant à l'inverse de la deuxième valeur de saturation, de préférence au moins deux fois supérieure à ladite distance de multiplication. De telle manière, on garantit une probabilité d'ionisation par impact dans la deuxième couche supérieure à 70%, de préférence supérieure à 90%.

Dans une variante de réalisation, l'épaisseur $e_2$ de la deuxième couche est contrôlée pour limiter l'occurrence de plusieurs multiplications par porteur tout en conservant une forte probabilité d'ionisation par impact. L'optimisation décrite ci-dessus de l'épaisseur de la première couche 21 fait qu'il est fortement probable que la probabilité d'ionisation par impact pour la première multiplication dans la deuxième couche 22 soit fortement augmentée après le passage dans la première couche 21. Cette augmentation est également stimulée par le passage entre le matériau de fort gap dans la première couche et le matériau de faible gap dans la deuxième couche 22, qui induit un excès d'énergie supplémentaire. Il en découle une augmentation de la valeur de saturation $\alpha_{h2}$ par rapport à celle observée pour une région de multiplication à teneur en cadmium homogène. Cette augmentation peut être exploitée pour limiter l'épaisseur $e_2$ de la deuxième couche afin de minimiser la probabilité de produire un deuxième événement de multiplication dans la même couche tout en maintenant une forte probabilité d'ionisation dans cette couche.

On peut ainsi prévoir que dans chaque structure multicouche l'épaisseur $e_2$ de la deuxième couche 22 est inférieure à la deuxième distance d'espace mort $x_{ds2}$. Avec une probabilité de multiplication proche de l'unité pour chaque électron entrant dans une deuxième couche, l'aléa de multiplication est encore plus réduit. On notera que la réduction de l'épaisseur $e_2$ de la deuxième couche 22 permet également de réduire la probabilité d'induire un événement de multiplication dans la première couche suivante. Et cette réduction de l'épaisseur $e_2$ peut permettre de définir une structure élémentaire dont l'épaisseur totale $e_t$ est inférieure à la distance d'espace mort $x_{ds1}$ de la première couche.

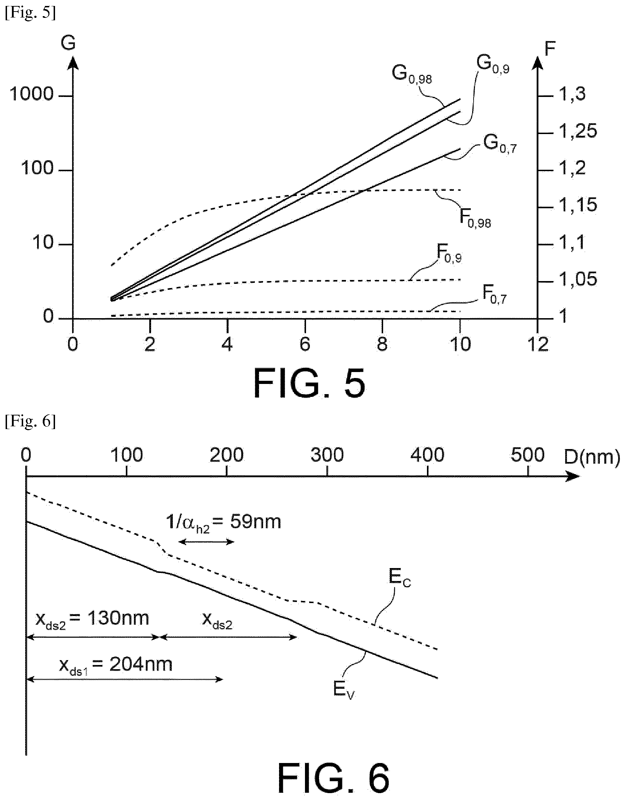

On a représenté sur la figure 5 l'évolution du gain G et du facteur d'excès de bruit F en fonction du nombre Np de structures élémentaires dans des photodiodes conformes à l'invention avec des probabilités de multiplication (unique) par électron dans la deuxième couche respectivement de 0,7 (conduisant à un gain $G_{0,7}$ et à un facteur d'excès de bruit $F_{0,7}$), de 0,9 (conduisant à un gain $G_{0,9}$ et à un facteur d'excès de bruit $F_{0,9}$) et de 0,98 (conduisant à un gain $G_{0,98}$ et à un facteur d'excès de bruit $F_{0,98}$). On rappelle que le facteur d'excès de bruit dans les photodiodes HgCdTe à couche de multiplication à teneur en cadmium homogène est de l'ordre de 1,2 à 1,3. On constate donc un facteur d'excès de bruit réduit pour les photodiodes selon l'invention. On observe notamment un facteur d'excès de bruit de l'ordre de 1,05 pour une probabilité d'ionisation de 0,9, ce qui permet de distinguer efficacement entre la détection d'un photon et la détection de deux photons simultanés.

On a représenté sur la figure 6 la variation de la largeur de bande interdite d'énergie (« gap ») qui sépare les bandes de valence Ev et de conduction Ec dans une structure multicouche sous polarisation inverse de 13V d'une photodiode selon un exemple de réalisation de l'invention à 7 structures multicouches. Dans cet exemple la première couche a une teneur en cadmium $x_{cd1}$=0,45 et une épaisseur $e_1$=130nm qui est ici égale à la deuxième distance d'espace mort $x_{ds2}$=130nm et inférieure à la première distance d'espace mort $x_{ds1}$=204nm. La deuxième couche a une teneur en cadmium $x_{cd2}$=0,34 et une épaisseur $e_2$=120nm qui est supérieure à la distance de multiplication $1/\alpha_{h2}$=59 nm. La

couche de gradient négatif a une épaisseur de 10 nm et la couche de gradient positif a une épaisseur de 30 nm. Les paramètres estimés du modèle d'ionisation par impact pour chacune des première et deuxième couche sont les suivants :

| | ds (V) | $\gamma$ | a ($V^{-1}$) | b (kV/cm) | $x_{ds}$=ds/E (nm) | $1/\alpha_h$ (nm) |
|---|---|---|---|---|---|---|
| Première couche 21 | 1,31 | 0,3 | 2,8 | 59 | 205 | 140 |
| Deuxième couche 22 | 0,83 | 0,3 | 4,4 | 38 | 130 | 59 |

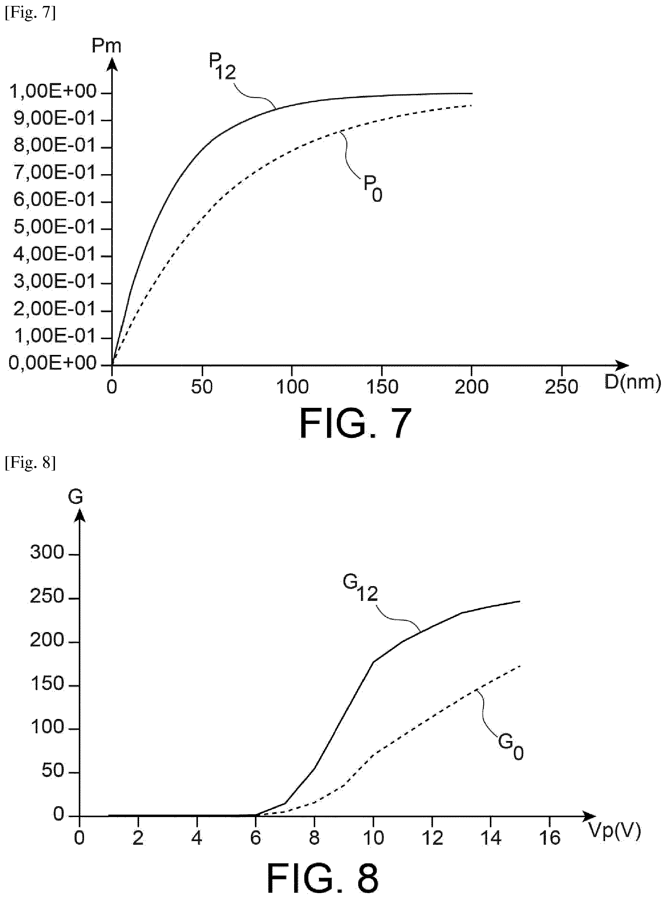

Sur la figure 7, la courbe $P_0$ représente la probabilité de multiplication Pm attendue pour un porteur dans une région de multiplication à teneur en cadmium homogène à une distance D de la fin de l'espace mort et pour une distance de multiplication de 59 nm. On constate que la probabilité de multiplication pour une épaisseur de 120 nm est de 0,85, ce qui correspond à un gain de 74 et un facteur d'excès de bruit de 1.08 pour une photodiode à 7 structures multicouches selon l'invention. Un gain plus important avec le même excès de bruit peut être obtenu avec un nombre plus important de structures multicouches dans la région de multiplication.

Comme on l'a vu précédemment, il est probable que la valeur de saturation du coefficient d'ionisation par impact dans une deuxième couche selon l'invention soit supérieure à la valeur attendue dans une région de multiplication à teneur en cadmium homogène. Sur la figure 7, la courbe $P_{12}$ illustre la probabilité de multiplication Pm attendue pour un porteur dans une deuxième couche selon l'invention en considérant une augmentation de la valeur de saturation d'un facteur 2. On constate qu'une probabilité de 0,98 est atteinte après 120 nm et qu'une probabilité de 0,89 est atteinte après seulement 70 nm. On peut donc opter pour une épaisseur $e_2$ identique afin d'optimiser le gain et le facteur d'excès de bruit ou bien réduire cette épaisseur pour faciliter la réalisation d'une région de multiplication respectant le critère $e_t < x_{ds1}$ tout en obtenant un faible excès de bruit.

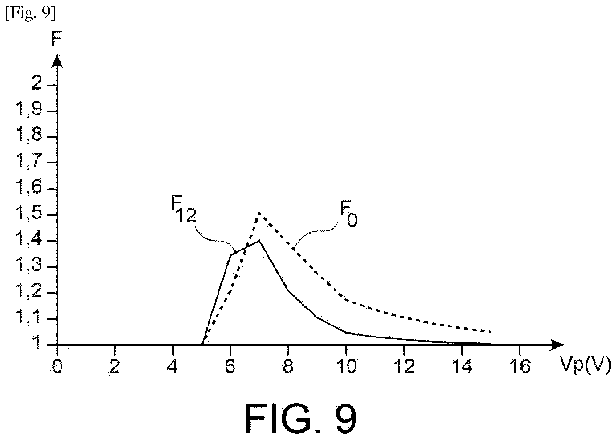

Les figures 8 et 9 représentent respectivement une estimation de l'évolution du gain G et une estimation de l'évolution du facteur d'excès de bruit en fonction de la tension de polarisation inverse Vp. Sur ces figures, les courbes $G_0$ et $F_0$ représentent respectivement l'évolution du gain et du facteur d'excès de bruit d'une photodiode disposant d'une une région de multiplication à teneur en cadmium homogène tandis que les courbes $G_{12}$ et $F_{12}$ représentent respectivement l'évolution du gain et du facteur d'excès de bruit d'une photodiode conforme à l'invention comprenant 8 structures multicouches et pour laquelle on a supposé une seule multiplication par deuxième couche et une augmentation de la valeur de saturation d'un facteur 2.

On notera qu'à forte polarisation, l'estimation du gain sature ce qui est induit par l'absence de prise en compte d'une double multiplication par deuxième couche dans le modèle utilisé. Or à une valeur de polarisation supérieure à 14V, cet effet de double multiplication devient important et contribue à une augmentation du gain et de l'excès de bruit. Ainsi le modèle utilisé n'est plus valable dans les zones rectangulaires des figures 8 et 9 qui correspondent à une tension Vp comprise entre 14 et 16V.

On déduit de la figure 9 qu'afin d'obtenir un faible excès de bruit, la photodiode selon l'invention doit être utilisée avec une polarisation suffisamment importante pour garantir une forte probabilité de multiplication dans la deuxième couche des structures multicouches. Dans l'exemple représenté, une tension supérieure à 9 V doit ainsi être appliquée à la photodiode selon l'invention (12 V pour la photodiode région de multiplication à teneur en cadmium homogène) pour observer un facteur d'excès de bruit inférieur à une valeur F=1,1. On choisit par exemple une tension de 12V pour atteindre un facteur d'excès de bruit proche de l'unité.

Dans une réalisation possible de l'invention, l'épaisseur de la première couche dans la première structure multicouche côté région d'absorption est augmentée, ce qui permet de bénéficier d'un coefficient d'ionisation par impact plus important dans la deuxième couche de cette première structure multicouche (qui forme la première couche de multiplication de la région de multiplication).

Dans une réalisation possible de l'invention, la région d'absorption présente une largeur de bande interdite d'énergie qui diminue en direction de la région de multiplication. Cette diminution peut être contrôlée via la teneur en cadmium. Elle permet de créer un champ électrique effectif qui permet d'accélérer le transit des porteurs vers la région de multiplication et de réduire le temps de réponse et l'instabilité temporelle de la photodiode.

Dans une réalisation possible de l'invention, la photodiode peut en outre comprendre une couche d'accélération des porteurs dudit seul type entre la région de multiplication et la région de collecte. Cette accélération permet de minimiser le temps de réponse de la photodiode comme par exemple décrit dans la publication EP 3 267 493 A1.

## Revendications

**1.** Photodiode à avalanche comprenant une région d'absorption (1), une région de collecte (3) et une région de multiplication (2) entre la région d'absorption et la région de collecte qui réalise une multiplication de porteurs par ionisation par impact dite d'un seul type de porteurs et telle que le taux de multiplication des électrons est au moins 50 fois plus élevé que le taux de multiplication des trous, photodiode à avalanche dans laquelle la région de multiplication comprend une pluralité de structures multicouches (20) où chaque structure multicouche comprend, de la région d'absorption vers la région de collecte, une première couche (21) présentant une première largeur de bande interdite d'énergie ($\Delta E_{21}$) puis une deuxième couche (22) présentant une deuxième largeur de bande interdite d'énergie ($\Delta E_{22}$), la première largeur de bande interdite d'énergie étant supérieure à la deuxième largeur de bande interdite d'énergie, la première couche (21) formant une couche d'accélération qui vient augmenter l'énergie des électrons sans initier d'événements de multiplication des électrons et la deuxième couche (22) formant une couche de multiplication au sein de laquelle sont localisés les événements de multiplication des électrons, **caractérisée en ce que** la photodiode à avalanche est réalisée à base de $Cd_xHg_{1-x}Te$ avec x correspondant à la proportion de cadmium par rapport au mercure ou à base $InAs_{1-x}Sb_x$ avec x correspondant à la proportion d'antimoine par rapport à l'arsenic.

2. Photodiode à avalanche selon la revendication 1, dans laquelle dans chaque structure multicouche la première couche (21) présente un taux de multiplication de porteurs par micromètre ayant une première valeur de saturation après une première distance d'espace mort, la deuxième couche présente (22) un taux de multiplication de porteurs par micromètre ayant une deuxième valeur de saturation après une deuxième distance d'espace mort et la première couche a une épaisseur qui est au moins égale à la deuxième distance d'espace mort et inférieure à la première distance d'espace mort.

3. Photodiode à avalanche selon la revendication 2, dans laquelle dans chaque structure multicouche la deuxième couche (22) a une épaisseur supérieure à une distance de multiplication correspondant à l'inverse de la deuxième valeur de saturation, de préférence au moins deux fois supérieure à ladite distance de multiplication.

4. Photodiode à avalanche selon l'une des revendications 2 et 3, dans laquelle dans chaque structure multicouche l'épaisseur de la deuxième couche (22) est inférieure à la deuxième distance d'espace mort.

5. Photodiode à avalanche selon la revendication 4, dans laquelle chaque structure multicouche a une épaisseur inférieure à la première distance d'espace mort.

6. Photodiode à avalanche selon l'une des revendications 1 à 5, dans laquelle la première couche de la structure multicouche au contact de la région d'absorption est plus épaisse que la première couche de la ou des autres structures multicouches.

7. Photodiode à avalanche selon l'une des revendications 1 à 6, dans laquelle chaque structure multicouche comprend, de la région d'absorption vers la région de collecte, une couche à gradient négatif de largeur de bande interdite d'énergie ($g_{12}$) entre la première couche et la deuxième couche et une couche à gradient positif de largeur de bande interdite ($g_{21}$) après la deuxième couche, le gradient négatif de largeur de bande interdite passant de la première largeur de bande interdite d'énergie à la deuxième largeur de bande interdite.

8. Photodiode à avalanche selon la revendication 7, dans laquelle le gradient positif de largeur de bande interdite passe de la deuxième largeur de bande interdite d'énergie à la première largeur de bande interdite.

9. Photodiode à avalanche selon l'une des revendications 7 et 8, dans laquelle la couche à gradient positif de largeur de bande interdite ($g_{21}$) est plus épaisse que la couche à gradient négatif de largeur de bande interdite ($g_{12}$).

10. Photodiode à avalanche selon l'une des revendications 1 à 9, dans laquelle les première et deuxième largeurs de bande interdite et les épaisseurs de la première et de la deuxième couche diminuent d'une structure multicouche à l'autre de la région d'absorption vers la région de collecte.

11. Photodiode à avalanche selon l'une des revendications 1 à 10, comprenant en outre une couche d'accélération des porteurs dudit seul type entre la région de multiplication et la région de collecte.

12. Photodiode à avalanche selon l'une des revendications 1 à 11, dans laquelle la région d'absorption (1) présente une largeur de bande interdite d'énergie qui diminue en direction de la région de multiplication.

**Patentansprüche**

1. Avalanche-Photodiode, einen Absorptionsbereich (1), einen Sammlungsbereich (3) und einen Vervielfachungsbereich (2) zwischen dem Absorptionsbereich und dem Sammlungsbereich umfassend, der eine Vervielfachung der Träger durch Stoßionisation eines einzigen Typs von Träger realisiert, und derart, dass die Rate der Elektronenvervielfachung mindestens 50 mal höher ist als die Rate der Löchervervielfachung, Avalanche-Photodiode, wobei der Vervielfachungsbereich eine Vielzahl von mehrschichtigen Strukturen (20) umfasst, wobei jede mehrschichtige Struktur, vom Absorptionsbereich zum Sammlungsbereich, eine erste Schicht (21) umfasst, die einen ersten Energiebandabstand ($\Delta E_{21}$) aufweist, und dann eine zweite Schicht (22), die einen zweiten Energiebandabstand ($\Delta E_{22}$) aufweist, wobei der erste Energiebandabstand größer ist als der zweite Energiebandabstand, wobei die erste Schicht (21) eine Beschleunigungsschicht bildet, die die Energie der Elektronen erhöht, ohne Ereignisse der Elektronenvervielfachung zu initiieren, und die zweite Schicht (22) eine Vervielfachungsschicht bildet, in der die Ereignisse der Elektronenvervielfachung lokalisiert sind,
   **dadurch gekennzeichnet, dass** die Avalanche-Photodiode auf der Basis von $Cd_xHg_{1-x}Te$ realisiert ist, wobei x dem Anteil an Cadmium relativ zu Quecksilber entspricht, oder auf der Basis von $InAs_{1-x}Sb_x$, wobei x dem Anteil von Antimon relativ zu Arsen entspricht.

2. Avalanche-Photodiode nach Anspruch 1, wobei in jeder mehrschichtigen Struktur die erste Schicht (21) eine Rate der Trägervervielfachung pro Mikrometer aufweist, die einen ersten Sättigungswert nach einer ersten Totraumdistanz hat, die zweite Schicht (22) eine Rate der Trägervervielfachung pro Mikrometer aufweist, die einen zweiten Sättigungswert nach einer zweiten Totraumdistanz hat, und die erste Schicht eine Dicke hat, die mindestens gleich der zweiten Totraumdistanz ist, und kleiner als die erste Totraumdistanz.

3. Avalanche-Photodiode nach Anspruch 2, wobei in jeder mehrschichtigen Struktur die zweite Schicht (22) eine Dicke hat, die größer ist als eine Vervielfachungsdistanz, die dem Kehrwert des zweiten Sättigungswerts entspricht, vorzugsweise mindestens doppelt so groß wie die Vervielfachungsdistanz.

4. Avalanche-Photodiode nach einem der Ansprüche 2 und 3, wobei in jeder mehrschichtigen Struktur die Dicke der zweiten Schicht (22) kleiner ist als die zweite Totraumdistanz.

5. Avalanche-Photodiode nach Anspruch 4, wobei jede mehrschichtige Struktur eine Dicke hat, die kleiner ist als die erste Totraumdistanz.

6. Avalanche-Photodiode nach einem der Ansprüche 1 bis 5, wobei die erste Schicht der mehrschichtigen Struktur in Kontakt mit dem Absorptionsbereich dicker ist als die erste Schicht der anderen mehrschichtigen Struktur(en).

7. Avalanche-Photodiode nach einem der Ansprüche 1 bis 6, wobei jede mehrschichtige Struktur, vom Absorptionsbereich zum Sammlungsbereich, eine Schicht mit negativem Gradienten des Energiebandabstands ($g_{12}$) zwischen der ersten Schicht und der zweiten Schicht umfasst, und eine Schicht mit positivem Gradienten des Bandabstands ($g_{21}$) nach der zweiten Schicht, wobei der negative Gradient des Bandabstands vom ersten Energiebandabstand zum zweiten Bandabstand verläuft.

8. Avalanche-Photodiode nach Anspruch 7, wobei der positive Gradient des Bandabstands vom zweiten Energiebandabstand zum ersten Bandabstand verläuft.

9. Avalanche-Photodiode nach einem der Ansprüche 7 und 8, wobei die Schicht mit positivem Gradienten des Bandabstands ($g_{21}$) dicker ist als die Schicht mit negativem Gradienten des Bandabstands ($g_{12}$).

10. Avalanche-Photodiode nach einem der Ansprüche 1 bis 9, wobei der erste und zweite Bandabstand und die Dicken der ersten und zweiten Schicht von einer mehrschichtigen Struktur zur anderen vom Absorptionsbereich zum Sammlungsbereich abnehmen.

11. Avalanche-Photodiode nach einem der Ansprüche 1 bis 10, ferner eine Beschleunigungsschicht der Träger des einzigen Typs zwischen dem Vervielfachungsbereich und dem Sammlungsbereich umfassend.

12. Avalanche-Photodiode nach einem der Ansprüche 1 bis 11, wobei der Absorptionsbereich (1) einen Energiebandabstand aufweist, der in Richtung des Vervielfachungsbereichs abnimmt.

**Claims**

1. An avalanche photodiode comprising an absorption region (1), a collection region (3) and a multiplication region (2) between the absorption region and the collection region which performs a carrier multiplication by impact ionisation called a single carrier multiplication and such that the multiplication rate of the electrons is at least 50 times higher than the multiplication rate of the holes, avalanche photodiode wherein the multiplication region comprises a plurality of multilayer structures (20) where each multilayer structure comprises, from the absorption region towards the collection region, a first layer (21) having a first energy band gap ($\Delta E_{21}$) then a second layer (22) having a second energy band gap ($\Delta E_{22}$), the first energy band gap being greater than the second energy band gap, the first layer (21) forming an acceleration layer which increases the energy of the electrons without initiating electron multiplication events and the second layer (22) forming a multiplication layer within which the electron multiplication events are located,
**characterised in that** the avalanche photodiode is made from $Cd_xHg_{1-x}Te$ with x corresponding to the proportion of cadmium relative to mercury or from $InAs_{1-x}Sb_x$ with x corresponding to the proportion of antimony relative to arsenic.

2. The avalanche photodiode according to claim 1, wherein in each multilayer structure the first layer (21) has a carrier multiplication rate per micrometre having a first saturation value after a first dead space distance, the second layer has (22) a carrier multiplication rate per micrometre having a second saturation value after a second dead space distance and the first layer has a thickness which is at least equal to the second dead space distance and less than the first dead space distance.

3. The avalanche photodiode according to claim 2, wherein in each multilayer structure the second layer (22) has a thickness greater than a multiplication distance corresponding to the inverse of the second saturation value, preferably at least twice as high as said multiplication distance.

4. The avalanche photodiode according to one of claims 2 and 3, wherein in each multilayer structure the thickness of the second layer (22) is less than the second dead space distance.

5. The avalanche photodiode according to claim 4, wherein each multilayer structure has a thickness less than the first dead space distance.

6. The avalanche photodiode according to one of claims 1 to 5, wherein the first layer of the multilayer structure in contact with the absorption region is thicker than the first layer of the other multilayer structure(s).

7. The avalanche photodiode according to one of claims 1 to 6, wherein each multilayer structure comprises, from the absorption region to the collection region, a layer with a negative energy band gap gradient ($g_{12}$) between the first layer and the second layer and a layer with a positive band gap gradient ($g_{21}$) after the second layer, the negative band gap gradient passing from the first energy band gap to the second band gap.

8. The avalanche photodiode according to claim 7, wherein the positive band gap gradient passes from the second energy band gap to the first band gap.

9. The avalanche photodiode according to one of claims 7 and 8, wherein the layer with a positive band gap gradient ($g_{21}$) is thicker than the layer with a negative band gap gradient ($g_{12}$).

10. The avalanche photodiode according to one of claims 1 to 9, wherein the first and second band gaps and the thicknesses of the first and the second layer decrease from one multilayer structure to the other from the absorption region to the collection region.

11. The avalanche photodiode according to one of claims 1 to 10, further comprising a carrier acceleration layer of said single type between the multiplication region and the collection region.

12. The avalanche photodiode according to one of claims 1 to 11, wherein the absorption region (1) has an energy band gap which decreases in the direction of the multiplication region.

[Fig. 1]

FIG. 1

[Fig. 2]

FIG. 2

[Fig. 3]

FIG. 3

[Fig. 4]

FIG. 4

[Fig. 5]

FIG. 5

[Fig. 6]

FIG. 6

[Fig. 7]

FIG. 7

[Fig. 8]

FIG. 8

[Fig. 9]

FIG. 9

**EP 3 660 929 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- US 6747296 B
- US 2013221193 A
- EP 3267493 A1

### Littérature non-brevet citée dans la description

- **J. ROTHMAN.** Physics and Limitations of HgCdTe APDs: A Review. *Journal of Electronic Materials,* 2018
- **J. ROTHMAN et al.** History-Dependent Impact Ionization Theory Applied to HgCdTe e-APDs. *Journal of Electronic Materials,* 2011, (40), 1757